# EUROPEAN PATENT APPLICATION

(11) **EP 4 239 660 A1**
(43) Date of publication of application: **06.09.2023**
(21) Application number: 22159871.7
(22) Date of filing: 03.03.2022
(51) Int. Cl.: H01L 21/48, H01L 23/498

(54) **METHOD OF ATTACHING A TERMINAL TO A METAL SUBSTRATE STRUCTURE FOR A SEMICONDUCTOR POWER MODULE AND SEMICONDUCTOR POWER MODULE**

(71) Applicant: Hitachi Energy Switzerland AG, 5400 Baden (CH)
(72) Inventor: Guillon, David, 8857 Vorderthal (CH); Bayer, Martin, 5036 Oberentfelden (CH); Roesch, Andreas, 79730 Murg (DE); Salvatore, Giovanni A., 34170 Gorizia (IT); Fischer, Fabian, 5400 Baden (CH)
(74) Representative: Epping - Hermann - Fischer

(57) **Abstract**

A method for attaching a terminal (4) to a metal substrate structure (3) for a semiconductor power module (10) comprises providing at least one terminal (4) and providing the metal substrate structure (3) with a metal top layer (17), a metal bottom layer (19) and an isolating resin layer (18) arranged between the metal top layer (17) and the metal bottom layer (19). The method further comprises providing and coupling a buffer structure element (7) to a top surface (171) of the metal top layer (17) to form a protrusion for the at least one terminal (4). The method further comprises coupling the at least one terminal (4) to the buffer structure element (7) by means of ultrasonic welding such that the buffer structure element (7) is arranged between the metal top layer (17) and the at least one terminal (4) and is materially bonded to the at least one terminal (4).

## Description

The present disclosure is related to a method for attaching a terminal to a metal substrate structure for a semiconductor power module with an isolating resin sheet. The present disclosure is further related to a semiconductor power module for a semiconductor device.

Conventional insulated metal substrates form technology for low and medium power semiconductor packages with low insulation requirements and low thermal resistance requirements simultaneously. Terminals are attached to the insulated metal substrate and there is a need for a reliable connection of the terminals on the insulated metal substrate.

Embodiments of the present disclosure relate to a method for attaching a terminal to a metal substrate structure that can contribute to a cost saving metal substrate structure for a semiconductor power module which enables reliable functioning even for high voltage power module applications. Further embodiments of the present disclosure relate to a corresponding semiconductor power module.

According to an embodiment, a method for attaching a terminal to a metal substrate structure for a semiconductor power module comprises providing at least one terminal and providing the metal substrate structure with a metal top layer, a metal bottom layer and an isolating resin layer arranged between the metal top layer and the metal bottom layer. The method further comprises providing and coupling a buffer structure element to a top surface of the metal top layer to form a protrusion for the at least one terminal. The method further comprises coupling the at least one terminal to the buffer structure element by means of ultrasonic welding with an ultrasonic welding head such that the buffer structure element is arranged between the metal top layer and the at least one terminal and is materially bonded to the at least one terminal.

Due to the described method realization of ultrasonic welded joining connections on an insulated metal substrate are possible which can contribute to a stable and reliable functioning of a semiconductor power module even for high voltage power module applications. The method contributes to secure and cost-efficient attachment of terminals on insulated metal substrates by ultrasonic welding with a reduced damage risk to the isolating resin layer, for example.

In view of alternative connecting processes the ultrasonic welding provides a reliability of ultrasonic welding interface towards thermal load cycles, improved thermal conduction from interface, ease manufacturability and throughput. Due to the buffer structure element it possible to use ultrasonic welding as an established technology also for insulated metal substrate structures. There is now need to redesign housings or terminals.

Insulated metal substrate structures realize a cost-effective technology for power semiconductor modules with low insulation and low thermal resistance requirements.

The buffer structure is an intentionally formed protrusion that enables protection of the resin layer against mechanical impact introduced by ultrasonic welding and realizes a locally larger thickness or reinforcement of a circuit metallization of the metal top layer on the position of the terminal. Additionally, the buffer structure provides protection of the resin layer against thermal impact. The protrusion provides a longer mechanical and thermal path between the welding position and the resin layer and a mechanical enforcement of the substrate.

The thicker or wider the buffer structure element is the less mechanical stress is introduced in the insulated metal substrate structure. In this respect, a height or thickness of the buffer structure element may have a larger impact on absorption or buffering for stress relaxation than a width or a length buffer structure element. Moreover, in order to contribute to stress buffering or absorption the buffer structure element can comprise a gold coating, for example, that enables to reduce friction forces. However, such a coating also contributes to reliable and stable attachment of the buffer structure element like for sintering, for example.

The ultrasonic welding process is performed in coordination with the terminal, the buffer structure element and the metal substrate structure. For example, the ultrasonic welding process is performed with an ultrasonic frequency in the range of 10-100 kHz, e.g. 20 kHz. For example, the ultrasonic welding process is performed with an amplitude of 10 µm up to 100 µm. The ultrasonic welding process can be performed with a predetermined mechanical pressure of 100 N up to 1000 N acting on the terminal, the buffer structure element and/or the metal substrate structure.

It is a recognition in connection with the present disclosure that conventional insulated metal substrates realize technologies for low and medium power semiconductor packages with low insulation requirements and low thermal resistance requirements simultaneously. For low reliability requirements, terminals can be soldered or glued on substrate. Usually, welding provides better reliability, but a welding process can be critical for the substrate structure. In view of conventional setups of such insulated metal substrates corresponding terminals are connected to a top metallization using welding techniques to provide joining connections which can be critical with respect to a stable process on the substrates and a resin isolation sheet below the metallization. The welding process can lead to damages of the substrate structure and for example ultrasonic welding provides a strong impact of thermal and mechanical stress on the substrate structure due to friction and pressure between a terminal foot and the substrate. Here a resin sheet is strongly endangered by deformation and crack formation. Furthermore, there is a risk of delamination of the metallization from the resin sheet layer. Corresponding failure modes can occur when applying ultrasonic welding of terminal feet on a circuit metallization of an insulated metal substrate.

By use of the described method for manufacturing a metal substrate structure with one or more attached terminals it is possible to counteract the aforementioned adverse effects due to the specifically introduced buffer structure element between the terminal and the metal top layer. The protrusion on the top surface of the metal top layer formed by the buffer structure element damps or reduces the mechanical and thermal stress caused by ultrasonic welding in view of the lower layers of the metal substrate structure. The buffer structure element can be formed by a separate metal element on the metal top layer and/or may be formed in one piece with the metal top layer. A risk of crack or damage formation in the resin layer and delamination of the metal top layer can be reduced and a stable semiconductor power module is feasible that enables reliable functioning even for high voltage power module applications in a voltage range of 0.5 kV up to 10.0 kV, for example.

According to an embodiment of the method the step of providing and coupling the buffer structure element comprises providing a metal block element separate from the metal top layer and coupling the metal block element to the top surface of the metal top layer by means of a joining layer. Alternatively or additionally, the step of providing and coupling the buffer structure element can comprise providing a metal block protrusion formed integrally with the metal top layer protruding from the top surface of the metal top layer.

According to a further embodiment of the method the buffer structure element is provided to form an intentionally placed protrusion by a metal block or spring element or elastic element with a height of 0.3 mm up to 2.0 mm, for example. The height relates to a dimension along the stacking direction of the metal substrate structure and the at least one terminal and can also be called a thickness of the protrusion extending above the adjacent top surface of the metal top layer.

The buffer structure element can be made of or comprise at least one of copper, copper alloy, aluminum and aluminum alloy or any other applicable metals or other conductive materials. The metal top layer can also be made of or comprise at least one of copper, copper alloy, aluminum and aluminum alloy or any other applicable metals or other conductive materials. The buffer structure element and the metal top layer comprise different or same material(s) with similar or identical coefficients of thermal expansion to provide similar or same thermal expansion, for example.

According to a further embodiment of the method, the buffer structure element is provided with a coating layer on a top surface that is configured to face a bottom surface of the at least one terminal during ultrasonic welding and/or with a coating layer on a bottom surface that is configured to face the top surface of the metal top layer during ultrasonic welding. Alternatively or additionally, there can be a coating layer on a bottom surface of the buffer structure that is configured to face the top surface of the metal top layer which is intended for facilitation of a joining connection between the buffer element and the substrate metallization.

Alternatively or additionally, the at least one terminal is provided with a first coating layer on a top surface that is configured to face the ultrasonic welding head during ultrasonic welding and/or a second coating layer on a bottom surface that is configured to face the metal top layer of the metal substrate structure during ultrasonic welding.

One or more of the aforementioned coating layer of the buffer structure element and the first and second coating layer of the terminal can be made of or comprise a noble metal, like nickel and/or silver and/or gold, and/or one or more other metals. Such a coating can contribute to prevent oxidation and/or to improve conditions of the ultrasonic welding process. The respective coating can partially or completely cover a predetermined surface of the buffer structure or the terminal. Moreover, the respective coating may comprise one or more layers.

The buffer structure can be joined to the circuit metallization of the metal top layer by at least one of soldering, gluing, sintering, and dry contact or any other suitable joining method. The circuit metallization or the metal top layer may have a corresponding coating as well. The buffer structure can be realized as a metal block or spring element or an elastic element to form a predetermined protrusion. The implementation of buffer structure on the top surface of the metal substrate structure is provided at a position, where the terminal is joined by ultrasonic welding. Moreover, there can be more than one buffer structure associated to more than one terminal. The buffer structure contributes to protection of the resin layer against mechanical and thermal impact, respectively.

The one or more terminals can be welded directly onto a respective buffer structure element and the buffer structure elements can attached directly onto the top surface of the metal top layer to form respective direct copper-to-copper contacts, for example. Alternatively to a direct contact, one or more coating layers can be located between surfaces facing each other. Thus, a coating layer can be located between a bottom surface of a respective terminal and an upper or top surface of the associated buffer structure element. Alternatively or additionally, a coating layer can be located between a bottom surface of the buffer structure element and the top surface of the metal top layer.

The buffer structure element can comprise a material provided with a yield strength that is larger than a yield strength of a material of the terminal or one of the joining partners. Alternatively or additionally, the buffer structure element comprises a material provided with a melting point that is higher than a melting point of a material of the terminal or one of the joining partners. Such specifications for the material of the joining partners can contribute to a secure and reliable ultrasonic welding process.

The resin layer forms a dielectric layer and can be realized as a pre-preg sheet which is assembled between two metal plates on top and bottom forming the metal top layer and the metal bottom layer. Such metallization sheets or plates are bonded to the dielectric resin layer by the lamination process, for example. A required metallization structure of the metal top layer can then be done by subsequent steps of masking and etching processes to locally remove conductive metal, creating the final metallization structure. Alternatively, the top metallization structure can be formed by cutting or stamping, for example before the formation of the finished metal substrate structure.

Alternatively, the resin layer can be formed by molding. With respect to such a molded dielectric layer, a molding substance realizes a pumpable substance with predetermined material properties. The pumpable substance is a liquid or viscous raw material of the resin layer to be formed. For example, the molding substance is an epoxy and/or ceramic based liquid. Alternatively or additionally, the raw material of the dielectric layer may be a thermosetting or a thermoplastic resin material such as polyamide, PBT, PET. Alternatively or additionally, the raw material of the dielectric layer may comprise inorganic filler, for example based on a ceramic material, for improved thermal conductivity and/or CTE adjustment with respect to the metal top layer and/or the metal bottom layer. For example, the molded dielectric layer comprises a resin based dielectric material with ceramic filling material, e.g. Al2O3, AlN, BN, Si3N4 or SiO2. For example, the dielectric layer is an epoxy with filler. The dielectric layer can be also based on other materials suitable for transfer, injection or compression molding or other applicable molding technologies such as bismaleimide, cyanate ester, polyimide and/or silicones. Alternatively or additionally, the dielectric layer can include a ceramic material and/or hydroset material or a material combination of two or more of the aforementioned components.

The aligning of the metal top layer and the metal bottom layer relative to each other with a predetermined distance in between will substantially predetermine the later thickness of the molded dielectric layer. For example, the thickness is defined along a stacking direction of the metal substrate structure which may present a z-direction. However, the alignment can also be done in the perpendicular x- and y-directions for proper positioning, e.g. of the metal pattern with respect to the x- and y-direction. For example, the alignment can be realized by placing the metal top layer onto a release film or liner or another fixation, for example in a mold chase of a molding tool. This enables to precisely position the provided metallization structure of the metal top layer relative to the metal bottom layer and can be useful if the metal top layer comprises separate metal pads due to different potentials of operation, for example. In case of lamination, a thickness of a resin layer is given by the thickness and the behavior of the laminated layer.

The thickness of the isolating resin layer can have a value of 100 µm up to 200 µm. A thickness of the metal top layer can have a value of 0.15 mm up to 2.00 mm. The height or thickness of the buffer structure element can have a value between 0.3 and 2.0 mm, for example. The terminal can comprise an L-shape with a terminal body extending mainly in the stacking direction and a terminal foot extending mainly in lateral directions substantially perpendicular to the stacking direction. The terminal foot may form a plate with a thickness of 0.5 mm up to 1.5 mm with respect to the stacking direction. The thickness of the terminal foot and/or the welding area formed by the ultrasonic welding process may be smaller compared with other portions of terminal, for example, to provide an ultrasonic welding process with reduced stress. The one or more terminals are made of or comprise copper or a copper alloy, for example, and can realize main or auxiliary terminals for electrical signal connections of the semiconductor power module.

The at least one terminal or buffer element can also comprise a structure prepared for improved ultrasonic welding. Such a welding structure can be realized by a roughed or thinned area, by one or more slots, grooves and/or recesses in a terminal foot of the terminal, for example. Such a welding structure can be prepared on a top and/or bottom side of the respective terminal or buffer element. Specific terminal structures can beneficially affect the ultrasonic welding process and can contribute to the formation of the materially bonding welding joint.

By use of the described manufacturing or attaching methods and the buffer structure element it is possible to counteract adverse effects even in use of the ultrasonic welding process. Thus, a risk of crack or damage formation, especially in the isolating resin sheet of the metal substrate structure, can be reduced and a stable semiconductor power module is feasible at low coast that enables reliable functioning of the semiconductor power module.

Finally, it is pointed out that all the proposed features and methods can be used solely, but also a combination of two or more.

According to an embodiment, a semiconductor power module comprises a metal top layer, a metal bottom layer and an isolating resin layer that is coupled with both the metal top layer and the metal bottom layer and that is arranged in between these layers. The semiconductor power module further comprises at least one terminal and a buffer structure element that is coupled to a top surface of the metal top layer forming a protrusion for the at least one terminal. The at least one terminal is coupled to the buffer structure element by means of ultrasonic welding with an ultrasonic welding head such that the buffer structure element is materially bonded to the at least one terminal and is arranged between the metal top layer and the at least one terminal.

As a result of that the described semiconductor power module can be manufactured by the embodiments of the method described above, the features and characteristics of the method are also disclosed with respect to the semiconductor power module and vice versa. Thus, the present disclosure comprises several aspects, wherein every feature described with respect to one of the aspects is also disclosed herein with respect to the other aspect, even if the respective feature is not explicitly mentioned in the context of the specific aspect.

According to an embodiment of the semiconductor power module the buffer structure element comprises a metal block element formed separate from the metal top layer and/or metal block element formed integrally with the metal top layer respectively protruding from the top surface of the metal top layer with a predetermined height in coordination with the performed ultrasonic welding process. The buffer structure element can comprise a height of 0.3 mm or 0.5 mm up to 2.0 mm with respect to an adjacent area of the top surface of the metal top layer and the stacking direction of the metal substrate structure and the at least one terminal. For example, the buffer structure element can comprise a height of 0.4 mm, 0.6 mm, 0.7 mm, 0.8 mm, 0.9 mm, 1.0 mm and so on up to 2.0 mm. A respective width and/or a length of the buffer structure element and/or the terminal, which correspond to a lateral directions perpendicular to the stacking direction of the metal substrate structure, can have a value of 2 mm up to 4 mm each, for example.

The semiconductor power module can further comprise a heat sink which is coupled with the metal bottom layer of the metal substrate structure to dissipate heat during operation of the semiconductor power module. The metal bottom layer forms a base of the metal substrate structure and can be made of or comprise copper, aluminum and/or a corresponding alloy. Thus, the semiconductor power module can comprise a separate heat sink. Alternatively or additionally, the metal bottom layer of the metal substrate structure can act as a heat sink itself and can be configured to comprise ribs, fins, or protrusion on the bottom side with respect to the stacking direction, for example, to provide a beneficial heat dissipation. The metal bottom layer can further act as a baseplate of the semiconductor power module.

The semiconductor power module including the metal substrate structure can be further partly or completely encapsulated by resin prepared by molding or potting or dielectric gel. Terminals may act as power terminals or as auxiliary terminals, e.g. used for signal wiring. Moreover, the semiconductor power module can comprise two or more embodiments of the aforementioned buffer structures. The semiconductor power module can further include electronics, for example chips, integrated circuits, sensors and/or other discrete devices.

The proposed process of ultrasonic welding of terminal feet on a buffer structure attached to insulated metal substrates has a strong potential to reduce the mechanical and thermal impact on the resin isolating sheet significantly. A successful ultrasonic welding process without damaging the heat- and pressure-sensitive resin layer is possible making the use of this comparably cost-effective substrate technology interesting. Such an attaching or manufacturing method for a metal substrate structure can be interesting for large power modules and power modules for higher voltage classes with enhanced reliability requirements. However, the described method also allows to manufacture metal substrate structures and semiconductor power modules that can be applied to miscellaneous products, for example low voltage industrial and automotive products operating in a voltage range of 0.5 kV or below. A large cost-down may be possible, when replacing a standard setup of ceramic substrates being soldered to a baseplate by an insulated metal substrate despite of the additional process step of joining metal blocks on terminal foot positions or preparation of local portions of the substrate top metallization with enhanced thickness. On the one hand material costs may be reduced, and on the other hand several other process steps like the joining process between substrate and baseplate in the power module assembly are not needed.

Exemplary embodiments are explained in the following with the aid of schematic drawings and reference numbers. The figures show:
- Figure 1: an embodiment of a method for attaching a terminal to a metal substrate structure of semiconductor power module in a side view;
- Figure 2: a further embodiment of a method for attaching a terminal to a metal substrate structure of semiconductor power module in a side view; and;
- Figure 3: a flow chart for a method of attaching an embodiment of the terminal to the metal substrate structure.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

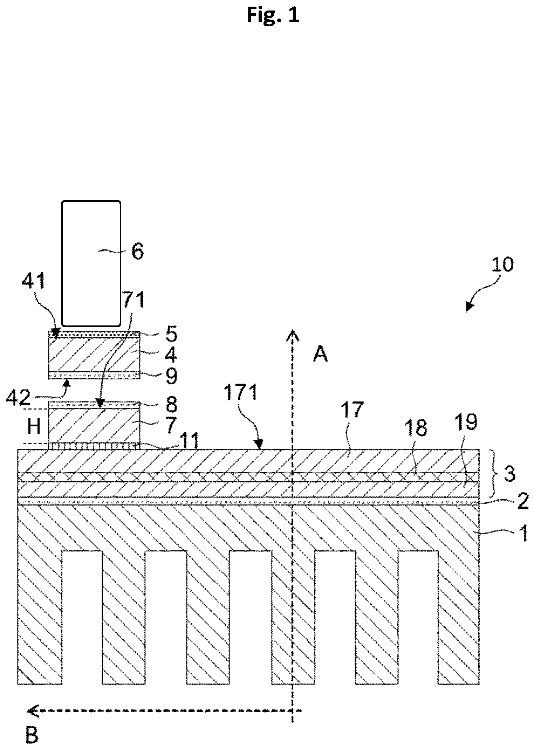

Figure 1 illustrates a side view of an embodiment of a method step for attaching a terminal foot or terminal 4 to a metal substrate structure 3 of a semiconductor power module 10 for a semiconductor device. The semiconductor power module 10 comprises the metal substrate structure 3 with a metal top layer 17, a metal bottom layer 19 and an isolating resin layer 18 arranged between the metal top layer 17 and the metal bottom layer 19 with respect to a stacking direction A.

The semiconductor power module 10 further comprises a cooler or heat sink 1 with a rib structure which is coupled with the metal substrate structure 3 by means of a bonding layer 2 and/or a layer of thermal interface material. With respect to the illustrated stacking direction A the terminal 4 is to be coupled to the metal top layer 17 and underneath the heat sink 1 is coupled with the metal bottom layer 19 via the bonding layer 2.

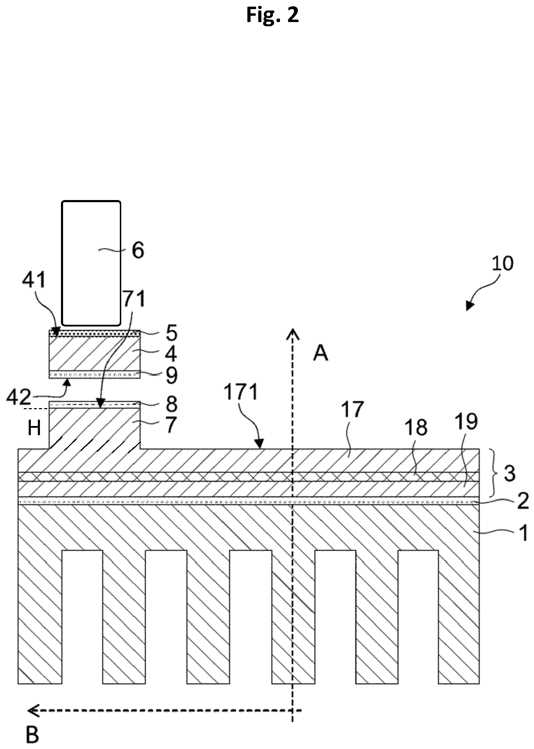

In this respect terms like "above", "under", "top", "upper" and "bottom" refer to an orientation or direction as illustrated in the figures and with respect to the staking direction A. Thus, a height or thickness of the described elements is related to the stacking direction A whereas a lateral direction B is orientated perpendicular to the stacking direction A (see Figs. 1 and 2).

A thickness of the isolating resin layer 18 can be between 100-200 µm, for example. A thickness of the circuit metallization that is formed by the metal top layer 17 can be between 0.15-2.00 mm. A thickness of the metal bottom layer 19 which may realize a baseplate can be between 2-5 mm and may also be configured to dissipate heat from the metal substrate structure 3 and the semiconductor power module 10. The resin layer 18 can comprise an epoxy resin material, but also another thermosetting resin or other types of resin like thermoplastic resin is possible. The resin layer 18 may be formed as a resin sheet or a pre-preg sheet that is assembled or laminated between the two metal layers 17, 19.

Alternatively or additionally, the metal substrate structure 3 comprises the resin layer 18 formed by means of molding, for example by means of injection, transfer or compression molding. The resin of the resin layer can contain inorganic filler, ceramic material, e.g. AlN, Si3N4, BN, Al2O3 or SiO2. The metal bottom layer 19 can be made of or comprise copper and/or aluminum and/or a corresponding alloy. The circuit metallization formed by the metal top layer 17 can be made of or comprise copper and/or aluminum and/or a corresponding alloy. Moreover, the metal top layer 17 may be coated partially or completely and a corresponding coating of the circuit metallization can be made of or comprise a noble metal, such as nickel and/or gold and/or silver, and/or other metals.

The semiconductor power module 10 further comprises a buffer structure element formed as a metal block element 7 made of or comprise copper, aluminum and/or a corresponding alloy and/or a corresponding alloy or other applicable conductive materials or metals. The metal block element 7 is configured to be attached to a top surface 171 of the metal top layer 17 to form a protrusion for the terminal 4 with a predetermined height H. The terminal 4 and the metal block element 7 are intended to be connected by means of ultrasonic welding with an ultrasonic welding head 6 such that the metal block element 7 is arranged between the metal top layer 17 and the terminal 4 and is materially bonded to the terminal 4.

The metal block element 7 is configured to form a protrusion on the top surface 171 of the metal top layer 17 that enables protection of the resin layer 18 against mechanical and thermal impact during the ultrasonic welding process. The metal block element 7 can be formed as a separate element attached to the metal top layer 17 by means of a joining layer 11 (see Fig. 1). Alternatively, the metal block element 7 can be formed integrally with the metal top layer 17 (see Fig. 2). Alternatively, the semiconductor power module 10 can comprise both a metal block element 7 formed as a separate element and one formed integrally with the metal top layer 17. For example, a separate metal block element 7 can be attached to an integrally one. Respectively, the metal block element 7 realizes a locally larger thickness or reinforcement of a circuit metallization of the metal top layer 17 on the position the terminal 4 is to be attached. The metal block element 7 can be made of or comprise copper, aluminum and/or a corresponding alloy and/or a corresponding alloy or any other applicable conductive material or metal. The metal block element 7 comprises a coating layer 8 arranged on an upper or top surface 71 of the metal block element 7 which partially or completely covers the top surface 71. Alternatively or additionally, a coating may be present on the bottom surface of the metal block element 7 if it is formed as a separate element, at least. The metal block coating 8 can improve the ultrasonic welding process and/or can be used, e.g. for protection against oxidation, but can also contribute to secure and reliable mounting of the metal block element 7 on the circuit metallization of the metal top layer 17 of the metal substrate structure 3. The metal block coating layer 8 can be made of or comprise a noble metal, such as nickel, silver and/or gold, and/or other metals. A respective coating can be formed comprising a single layer or stack of multiple layers. In the case, the metal block element 7 is formed as a separate element it can be connected to the top surface 171 of the metal top layer 17 by means of soldering, sintering, gluing, dry contact and/or another applicable joining method.

The terminal 4 can be made of or comprise copper, aluminum and/or a corresponding alloy and may realize a main or an auxiliary terminal of the semiconductor power module 10. Moreover, the terminal 4 can comprise a first coating layer 5 which partially or completely covers a top surface 41 of terminal 4. The terminal 4 can further comprise a second coating layer 9 which partially or completely covers a bottom surface 42 of terminal 4. The first and second coating layers 5, 9 can beneficially affect the ultrasonic welding process and/or protects the surface(s) of the terminal 4 from oxidation and may be made of or comprise a noble metal, such as nickel, gold, silver, and/or other metals. The lower second coating layer 9 may also be useful for attaching the terminal 4 to the metal block element 7.

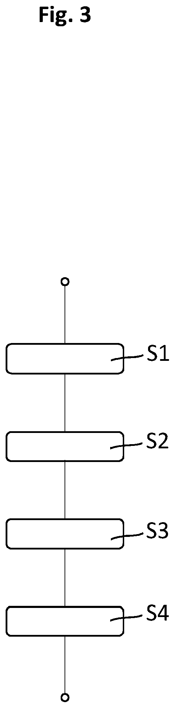

Steps of the method for attaching the terminal 4 to the metal substrate structure 3 can follow the flow chart as shown in Figure 3. For example, according to the embodiment illustrated in Figure 1 in a step S1 at least one terminal 4 is provided. The terminal 4 can be provided comprising the first and/or the second coating layer 5, 9 on its top and/or bottom surface 41, 42.

In a step S2 the metal substrate structure 3 is provided with the metal top layer 17, the metal bottom layer 19 and the isolating resin layer 18 arranged therebetween. A coating layer may be also available on a surface of the metal substrate structure 3 at least locally.

In a step S3 the metal block element 7, for example, is provided as a separate element and joined to the metallization of the metal top layer 17 on the intended terminal position to form a protrusion for the terminal 4 on the top surface 171 of the metal top layer 17. Alternatively or additionally, the metal block element 7 can be provided formed integrally with the metallization of the metal top layer 17. The metal block element 7 can be provided with the coating layer 8 on its top surface 71. Alternatively or additionally, there can be a coating of a respective backside metal block element 7 if it is formed as a separate element.

In a further step S4 the terminal 4 is welded to the metal block element 7 and thereby coupled with the metal top layer 17 of the metal substrate structure 3 by means of ultrasonic welding with the ultrasonic welding hear 6. Due to the welding process a welding joint between the terminal 4 and the metal block element 7 is formed and the terminal 4 and the metal block element 7 are firmly and materially bonded.

If the metal block element 7 is formed integrally with the metal top layer 17 (see Fig. 2) it realizes a given thicker part of the circuit metallization of the metal top layer 17 with a predetermined thickness or height H. In this case, the metal block element 7 is provided and joined to the metal top layer 17 already in step S2 or is even available. In this case, the protrusion is realized in the manufacturing of the metal top layer 17 itself. In step S3 the coating layer 8 can be provided on the top surface 71 of the metal block element 7, for example. This can also be realized in step 2, where the provided metal substrate structure 3 also has a coating layer.

The arrangement of the metal block element 7 between circuit metallization or the metal top layer 17 and the terminal 4 provides protection for the resin layer 18 and also enables improvement of the ultrasonic welding process. The metal block element 7 may have a thickness or height H of 0.3 mm up to 2.0 mm.

The described embodiments are related to ultrasonic welding of power and auxiliary terminals 4 on insulated metal substrates or insulated metal baseplates as realized by the metal substrate structure 3. The insulated metal substrates can be prepared by lamination or molding technologies, e.g. using stamped metal sheets for circuit metallization forming the metal top layer 17. Thus, it is also feasible on substrate structures basing on alternative insulated metal substrate technologies like stamped and molded metal substrates. The ultrasonic welding process is facilitated by the buffer structure comprising the metal block element 7 arranged between the top metallization of the insulated metal substrate and a foot of the terminal 4.

In contrast to a conventional substrate basing on a ceramic isolating sheet, the insulated metal substrate consists of a relative thick metal base mostly made of aluminum or copper or a corresponding alloy, an isolating sheet basing on resin material, and a circuit metallization made of aluminum or copper or a corresponding alloy. The resin material used for the isolating resin layer 18 is an epoxy resin containing a heat conductive inorganic filler material, for example. Such a filler material can consist of ceramic particles prepared from aluminum nitride (AlN), silicon nitride (Si3N4), boron nitride (BN), and/or aluminum oxide (Al2O3).

The mechanical and thermal impact of the ultrasonic welding process on the resin isolating layer 17 is reduced or suppressed by the implementation of the buffer structure in form of the metal block element 7 between the top surface 171 of the metal substrate structure 3 and the foot of the terminal 4. The welding connection is then prepared between the foot of the terminal 4 and the metal block element 7, so that mechanical stress and heat mostly occur in the metal block element and in the terminal foot, but not or at least less in the metal substrate structure 3 itself. The metal block element 7 is joined to the top surface 171 of the circuit metallization of the metal top layer 17 before the ultrasonic welding of the main or auxiliary terminal 4, for example. Soldering, gluing, sintering, dry contacting, or any other applicable joining method may be used for fixation of the metal block element 7 onto the top surface 171. Alternatively, the metal block element 7 can be joined to the top surface 171 of the circuit metallization of the metal top layer 17 afterwards the ultrasonic welding of the main or auxiliary terminal 4 to the metal block element 7 to prevent mechanical impact on the isolating resin layer 18.

Instead of the use of an additional metal block element 7 to be used as buffer structure as illustrated in Figure 1, also a specific modification of the circuit metallization of the metal top layer 17 of the insulated metal substrate structure 3 is possible. Here a buffer structure between the circuit metallization and the foot of the terminal 4 is realized by a locally thicker substrate metallization on the position of the terminal 4 (see Fig. 2). Similar to the first embodiment, the locally thicker part of the circuit metallization also realizes the metal block element 7 formed integrally.

The embodiments shown in the Figures 1 to 2 as stated represent exemplary embodiments of the improved metal substrate structure 3, the semiconductor power module 10 and the manufacturing method for; therefore, they do not constitute a complete list of all embodiments. Actual arrangements and methods may vary from the embodiments shown in terms of metal substrate structures 3 and semiconductor power modules 10, for example.

### Reference signs

- 1: heat sink
- 2: bonding layer
- 3: metal substrate structure
- 4: terminal
- 41: top surface of the terminal
- 42: bottom surface of the terminal
- 5: first coating layer
- 6: ultrasonic welding head
- 7: buffer structure element / metal block/protrusion
- 71: top surface of the metal block element
- 8: metal block coating layer
- 9: second coating layer
- 10: semiconductor power module
- 11: joining layer
- 17: metal top layer
- 171: top surface of the metal top layer
- 18: resin layer
- 19: metal bottom layer

- A: stacking direction
- B: lateral direction
- H: height of the buffer structure
- S(i): steps of a method for manufacturing a metal substrate structure for a semiconductor power module

## Claims

1. A method for attaching a terminal (4) to a metal substrate structure (3) for a semiconductor power module (10), comprising:
- providing at least one terminal (4),
- providing the metal substrate structure (3) with a metal top layer (17), a metal bottom layer (19) and an isolating resin layer (18) arranged between the metal top layer (17) and the metal bottom layer (19),
- providing and coupling a buffer structure element (7) to a top surface (171) of the metal top layer (17) to form a protrusion for the at least one terminal (4), and
- coupling the at least one terminal (4) to the buffer structure element (7) by means of ultrasonic welding with an ultrasonic welding head (6) such that the buffer structure element (7) is arranged between the metal top layer (17) and the at least one terminal (4) and is materially bonded to the at least one terminal (4).

2. The method according to claim 1, wherein the step of providing and coupling the buffer structure element (7) comprises:
- providing a metal block element separate from the metal top layer (17), and
- coupling the metal block element to the top surface (171) of the metal top layer (17) by means of a joining layer (11) .

3. The method according to claim 1 or 2, wherein the step of providing and coupling the buffer structure element (7) comprises:
- providing a metal block protrusion formed integrally with the metal top layer (17) protruding from the top surface (171) of the metal top layer (17).

4. The method according to one of the preceding claims, wherein the buffer structure element (7) is provided with a height (H) of 0.3 - 2.0 mm with respect to an adjacent area of the top surface (171) of the metal top layer (17) and a stacking direction (A) of the metal substrate structure (3) and the at least one terminal (4).

5. The method according to one of the preceding claims, wherein the buffer structure element (7) and the metal top layer (17) are provided comprising at least one of copper, copper alloy, aluminum and aluminum alloy .

6. The method according to one of the preceding claims, wherein the step of providing the buffer structure element (7) comprises:
providing the buffer structure element (7) with a coating layer (8) on a top surface (71) that is configured to face a bottom surface (42) of the at least one terminal (4) during ultrasonic welding and/or with a coating layer (11) on a bottom surface that is configured to face the top surface (171) of the metal top layer (17) during ultrasonic welding.

7. The method according to one of the preceding claims, wherein the step of providing the at least one terminal (4) comprises:
providing the at least one terminal (4) with a first coating layer (5) on a top surface (41) that is configured to face the ultrasonic welding head (6) during ultrasonic welding and/or a second coating layer (9) on a bottom surface (42) that is configured to face the metal top layer (17) of the metal substrate structure (3) during ultrasonic welding.

8. The method according to claim 6 or 7, wherein at least one of the coating layer (8) of the buffer structure element (7) and the first coating layer (5) of the terminal (4) and the second coating layer (9) of the terminal (4) comprises nickel and/or silver and/or gold.

9. The method according to one of the preceding claims, wherein the buffer structure element (7) is coupled to the metal top layer (17) by means of at least one of soldering, sintering, gluing and dry contact.

10. The method according to one of the preceding claims, wherein the buffer structure element (7) comprises a material provided with a yield strength that is larger than a yield strength of a material of the terminal (4) or the metal top layer (17).

11. The method according to one of the preceding claims, wherein the buffer structure element (7) comprises a material provided with a melting point that is higher than a melting point of a material of the terminal (4) or the metal top layer (17).

12. A semiconductor power module (10), comprising:
- metal substrate structure (3) with a metal top layer (17), a metal bottom layer (19), and an isolating resin layer (18) that is coupled with both the metal top layer (17) and the metal bottom layer (19) in between,
- at least one terminal (4), and
- a buffer structure element (7) that is coupled to a top surface (171) of the metal top layer (17) forming a protrusion for the at least one terminal (4), wherein the at least one terminal (4) is coupled to the buffer structure element (7) by means of ultrasonic welding with an ultrasonic welding head (6) such that the buffer structure element (7) is materially bonded to the at least one terminal (4) arranged between the metal top layer (17) and the at least one terminal (4).

13. The semiconductor power module (10) according to claim 12, wherein the buffer structure element (7) comprises a metal block element formed separate from the metal top layer (17) and/or a metal block protrusion formed integrally with the metal top layer (17) respectively protruding from the top surface (171) of the metal top layer (17).

14. The semiconductor power module (10) according to claim 12 or 13, wherein the buffer structure element (7) is provided with a height (H) of 0.3 - 2.0 mm with respect to an adjacent area of the top surface (171) of the metal top layer (17) and a stacking direction (A) of the metal substrate structure (3) and the at least one terminal (4).

15. The semiconductor power module (10) according to one of the claims 12-14, wherein at least one of the buffer structure element (7), the terminal (4) and the metal top layer (17) comprises coating layer (5, 8, 9, 11) on a respective top surface (41, 71, 171) that is configured to face the ultrasonic welding head (6) during ultrasonic welding and/or on a respective bottom surface (42) that is configured to face the metal top layer (17) of the metal substrate structure (3) during ultrasonic welding.
